# EUROPEAN PATENT APPLICATION

(11) **EP 2 202 621 A1**
(43) Date of publication of application: **30.06.2010**
(21) Application number: 09172937.6
(22) Date of filing: 13.10.2009
(51) Int. Cl.: G06F 3/041, G06F 3/01

(54) **Portable electronic device including touch-sensitive display and method of controlling same to provide tactile feedback**

(30) Priority: 23.12.2008 EP 08172725
(71) Applicant: Research In Motion Limited, Waterloo, Ontario N2L 3W8 (CA)
(72) Inventor: Paleczny, Todd Robert, Waterloo Ontario N2L 3W8 (CA); Weber, Arnett Ryan, Waterloo Ontario N2L 3W8 (CA)
(74) Representative: Roberts, Gwilym Vaughan

(57) **Abstract**

A method includes determining an adjustable response setting for an electronic device, detecting a touch event on a touch-sensitive display of the electronic device, and imparting, by an actuator, a first force on the touch-sensitive display by increasing the first force over a ramp-up time period and reducing the first force over a depression time period, to simulate actuation of a switch based on the adjustable response setting.

## Description

### FIELD OF TECHNOLOGY

The present disclosure relates to electronic devices, including but not limited to touch-sensitive displays.

### BACKGROUND

Electronic devices, including portable electronic devices, have gained widespread use and may provide a variety of functions including, for example, telephonic, electronic messaging and other personal information manager (PIM) application functions. Portable electronic devices include several types of devices including mobile stations such as simple cellular telephones, smart telephones, wireless PDAs, and laptop computers with wireless 802.11 or Bluetooth capabilities.

Portable electronic devices such as PDAs or smart telephones are generally intended for handheld use and ease of portability. Smaller devices are generally desirable for portability. A touch-sensitive display, also known as a touchscreen display, is particularly useful on handheld devices, which are small and have limited space for user input and output. The information displayed on the touch-sensitive displays may be modified depending on the functions and operations being performed.

Improvements in devices with touch-sensitive displays are desirable.

### BRIEF DESCRIPTION OF THE DRAWINGS

FIG. 1 is a block diagram of a portable electronic device in accordance with the present disclosure.

FIG. 2A is a front view of an example of a portable electronic device in accordance with the present disclosure.

FIG. 2B is a sectional side view of the portable electronic device through the line 202 of FIG 2, in accordance with the present disclosure.

FIG. 3 is a functional block diagram showing components of the portable electronic device in accordance with the present disclosure.

FIG. 4 is an example of a graph of voltage across a piezo actuator versus time during actuation in accordance with the present disclosure.

FIG. 5 is an example of a touch-sensitive display before and after adjustment of a response setting in accordance with the present disclosure.

FIG. 6 is a flowchart illustrating a method of controlling an electronic device in accordance with the present disclosure.

### DETAILED DESCRIPTION

The following describes an electronic device, such as a portable electronic device, and method of controlling the electronic device. The method includes providing an adjustable response setting for an electronic device, detecting a touch event on a touch-sensitive display of the electronic device, and imparting, by an actuator, a first response force on the touch-sensitive display by increasing the force over a ramp-up time period and reducing the force over a depression time period, to simulate actuation of a switch, such as a dome switch, based on the adjustable response setting.

For simplicity and clarity of illustration, reference numerals may be repeated among the figures to indicate corresponding or analogous elements. Numerous specific details are set forth to provide a thorough understanding of the embodiments described herein. The embodiments may be practiced without these specific details. In other instances, well-known methods, procedures, and components have not been described in detail so as not to obscure the embodiments described herein. The description is not to be considered as limited to the scope of the embodiments described herein.

The disclosure generally relates to an electronic device, which in the embodiments described herein is a portable electronic device. Examples of portable electronic devices include mobile, or handheld, wireless communication devices such as pagers, cellular phones, cellular smart-phones, wireless organizers, personal digital assistants, wirelessly enabled notebook computers, and the like. The portable electronic device may also be a portable electronic device without wireless communication capabilities such as a handheld electronic game device, digital photograph album, digital camera, or other device.

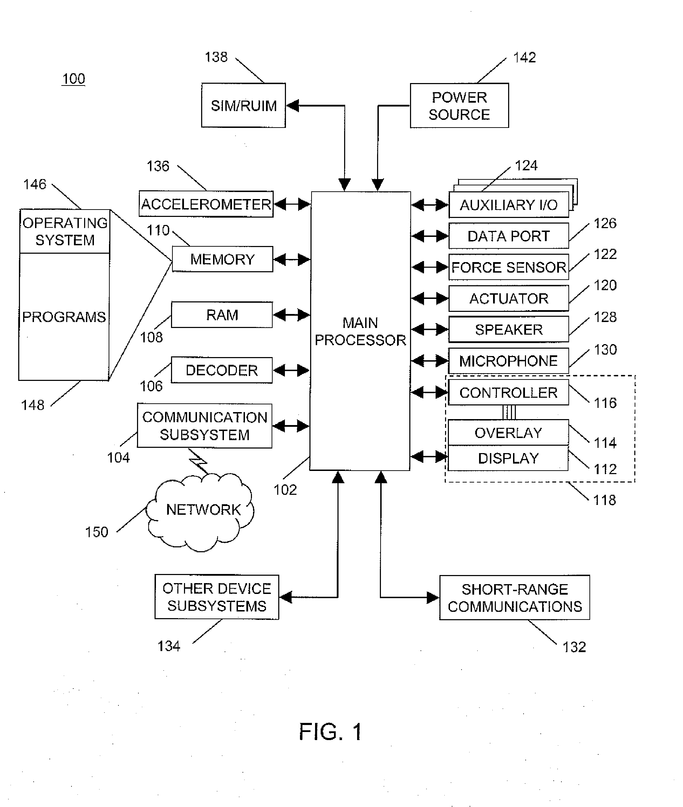

A block diagram of an example of a portable electronic device 100 is shown in FIG. 1. The portable electronic device 100 includes multiple components, such as a processor 102 that controls the overall operation of the portable electronic device 100. Communication functions, including data and voice communications, are performed through a communication subsystem 104. Data received by the portable electronic device 100 is decompressed and decrypted by a decoder 106. The communication subsystem 104 receives messages from and sends messages to a wireless network 150. The wireless network 150 may be any type of wireless network, including, but not limited to, data wireless networks, voice wireless networks, and dual-mode networks that support both voice and data communications. A power source 142, such as one or more rechargeable batteries or a port to another power supply, powers the portable electronic device 100.

The processor 102 interacts with other devices, such as a Random Access Memory (RAM) 108, memory 110, a display 112 with a touch-sensitive overlay 114 operably connected to an electronic controller 116 that together comprise a touch-sensitive display 118, one or more actuators 120, one or more force sensors 122, an auxiliary input/output (I/O) subsystem 124, a data port 126, a speaker 128, a microphone 130, short-range communications 132 and other device subsystems 134. User-interaction with a graphical user interface is performed through the touch-sensitive overlay 114. The processor 102 interacts with the touch-sensitive overlay 114 via the electronic controller 116. Information, such as text, characters, symbols, images, icons, and other items that may be displayed or rendered on a portable electronic device, is displayed on the touch-sensitive display 118 via the processor 102. The processor 102 may also interact with an accelerometer 136 that may be utilized to detect direction of gravitational forces or gravity-induced reaction forces.

To identify a subscriber for network access, the portable electronic device 100 uses a Subscriber Identity Module or a Removable User Identity Module (SIM/RUIM) card 138 for communication with a network, such as the wireless network 150. Alternatively, user identification information may be programmed into the memory 110.

The portable electronic device 100 also includes an operating system 146 and software programs or components 148 that are executed by the processor 102 and are typically stored in a persistent, updatable store such as the memory 110. Additional applications or programs may be loaded onto the portable electronic device 100 through the wireless network 150, the auxiliary I/O subsystem 124, the data port 126, the short-range communications subsystem 132, or any other suitable subsystem 134.

A received signal such as a text message, an e-mail message, or web page download is processed by the communication subsystem 104 and input to the processor 102. The processor 102 processes the received signal for output to the display 112 and/or to the auxiliary I/O subsystem 124. A subscriber may generate data items, for example e-mail messages, which may be transmitted over the wireless network 150 through the communication subsystem 104. For voice communications, the overall operation of the portable electronic device 100 is similar. The speaker 128 outputs audible information converted from electrical signals, and the microphone 130 converts audible information into electrical signals for processing.

The touch-sensitive display 118 may be any suitable touch-sensitive display, such as a capacitive, resistive, infrared, or surface acoustic wave (SAW) touch-sensitive display, as known in the art. A capacitive touch-sensitive display includes the display 112 and a capacitive touch-sensitive overlay 114. The overlay 114 may be an assembly of multiple layers in a stack including, for example, a substrate, LCD display 112, a ground shield layer, a barrier layer, one or more capacitive touch sensor layers separated by a substrate or other barrier, and a cover. The capacitive touch sensor layers may be any suitable material, such as patterned indium tin oxide (ITO).

One or more touches, also known as touch contacts or touch events, may be detected by the touch-sensitive display 118 and processed by the controller 116, for example, to determine a location of a touch. Touch location data may include a single point of contact, such as a point at or near a center of the area of contact, or the entire area of contact for further processing. The location of a touch detected on the touch-sensitive display 118 may include x and y components, e.g., horizontal and vertical with respect to one's view of the touch-sensitive display 118, respectively. For example, the x component may be determined by a signal generated from one touch sensor layer, and the y component may be determined by a signal generated from another touch sensor layer. A signal is provided to the controller 116 in response to detection of a suitable object, such as a finger, thumb, or other items, for example, a stylus, pen, or other pointer, depending on the nature of the touch-sensitive display 118. More than one simultaneous location of contact may occur and be detected.

A gesture, as utilized herein, is a touch, the location of which moves along the touch-sensitive display 138. The touch begins at an origin point and follows a path while touch contact is maintained. A gesture may be long or short in distance or duration or both distance and duration. A gesture may also be detected by the touch-sensitive display 118.

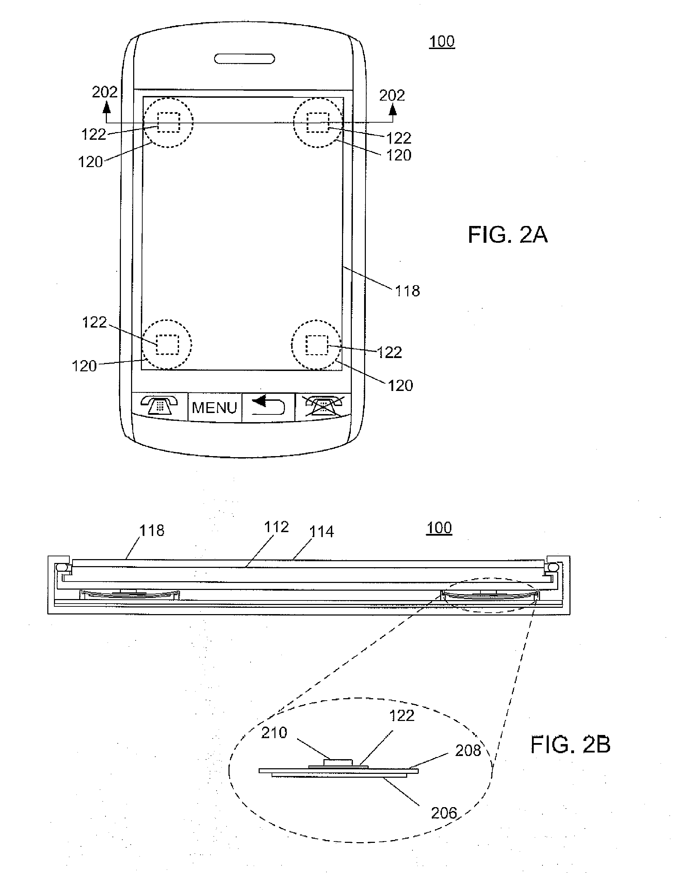

The actuator 120 may comprise one or more piezoelectric (piezo) actuators that provide tactile feedback. FIG. 2A is front view of an example of a portable electronic device 100. In the example shown in FIG. 2A, the actuator 120 comprises four piezo actuators 120, each located near a corner of the touch-sensitive display 118. FIG. 2B is a sectional side view of the portable electronic device 100 through the line 202 of FIG 2A. Each piezo actuator 120 is supported within the portable electronic device 100 such that contraction of the piezo actuators 120 applies a force against the touch-sensitive display 118, opposing a force externally applied to the display 118. Each piezo actuator 120 includes a piezoelectric device, such as a piezoelectric ceramic disk 206 adhered to a substrate 208, such as a metal substrate. An element 210 that is advantageously at least partially flexible and comprises, for example, hard rubber, may be located between the piezo disk 206 and the touch-sensitive display 118. The element 210 does not substantially dampen the force applied to or on the touch-sensitive display 118. In the example shown in FIG. 2A, four optional force sensors 122 are utilized, with each force sensor 122 located between the element 210 and the substrate 208. The substrate 208 bends when the piezo disk 206 contracts diametrically due to build up of charge at the PZT disk 206 or in response to an external force applied to the touch-sensitive display 118. The charge may be adjusted by varying the applied voltage or current, thereby controlling the force applied by the piezo actuators 120 on the touch-sensitive display 118. The charge on the piezo actuators 120 may be removed by a controlled discharge current that causes the piezo disk 206 to expand diametrically, decreasing the force applied by the piezo actuators 120 on the touch-sensitive display 118. Absent an external force applied to the overlay 114 and absent a charge on the piezo disk 206, the piezo actuator 120 may be slightly bent due to a mechanical preload.

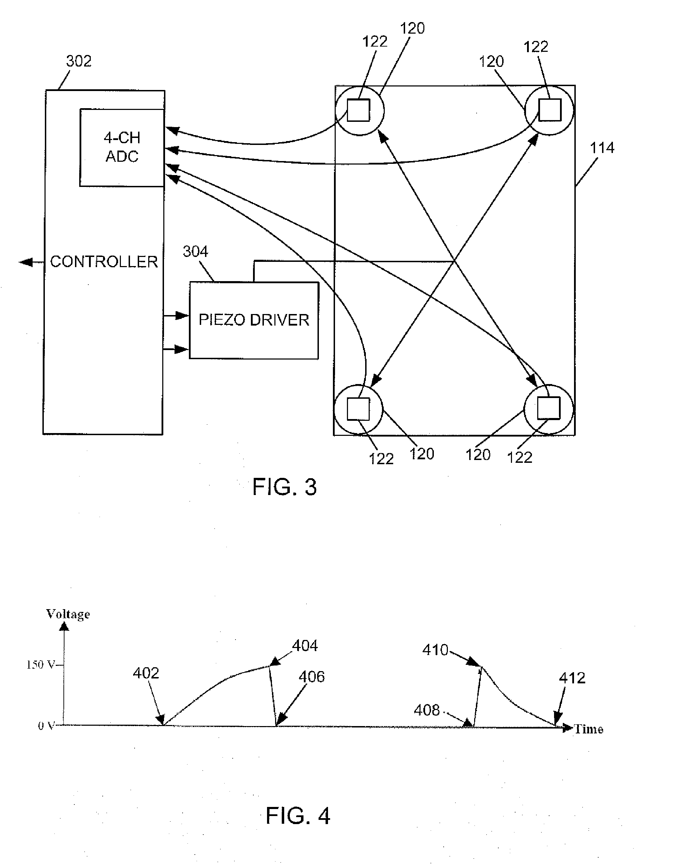

FIG. 3 shows a functional block diagram of components of the portable electronic device 100. In this example, each force sensor 122 is connected to a controller 302, which includes an amplifier and analog-to-digital converter (ADC). The force sensors 122 may be force-sensing resistors in an electrical circuit, where resistance changes in response to the force applied. As applied force on the touch-sensitive display 118 increases, the resistance decreases. This change is determined via the controller 116 for each of the force sensors. The applied force of a touch is determined based on a value of force at each of the force sensors 122.

The piezo actuators 120 are connected to a piezo driver 304 that communicates with the controller 302. The controller 302 is also in communication with the main processor 102 of the portable electronic device 10 and may receive and provide signals to the main processor 102. The piezo driver 304 may optionally be embodied in drive circuitry between the controller 302 and the piezoelectric disks 312. The controller 302 controls the piezo driver 304 that controls the current to the piezo disks 206 and thus controls the charge and the force applied by the piezo actuators 120 on the touch-sensitive display 118. Each of the piezo disks 206 may be controlled substantially equally and concurrently. Optionally, the piezo disks 206 may be controlled separately. The piezo disks 206 may be controlled provide tactile feedback via the touch-sensitive display 118, for example, to simulate depression or actuation of a switch, such as switch that may be utilized as part of a physical key of a keyboard, e.g., a dome switch, snap switch, or any other type of switch that may be simulated. Other types of tactile feedback may also be provided via such control. Such tactile feedback is provided in response to depression and release of the touch-sensitive display. When a force externally applied on the touch-sensitive display 118 exceeds a depression threshold, the charge at the piezo actuators 120 may be adjusted or varied, e.g., modulated, to impart a force on the touch-sensitive display to simulate depression or actuation of a switch, for example, collapse of a dome switch. When the applied force on the touch-sensitive display 118 falls below a second threshold, after actuation of the piezo actuators 120, the charge at the piezo actuators 120 may be controlled to impart a force, by the piezo actuators 120 on the touch-sensitive display 118, to simulate release of a switch, such as a dome switch. The second threshold is lower than the depression threshold.

A graph of voltage across the piezo disks 206 for a press and release of the touch-sensitive display 118 is shown is shown in FIG. 4. The voltage shown across one of the piezo disks 206 versus time is shown, which voltage is related to the charge. The external force applied on the touch-sensitive display 118 exceeds the first force threshold at 402 and the charge at the piezo disk 206 is adjusted or varied, e.g., modulated, between the points 402, 406 to ramp up the charge over a period of time that is sufficiently long such that a user does not detect the force. The charge on the piezo disk 206 is removed over a much shorter period of time relative to the period of time for ramp up to simulate depression of a switch, such as the collapse of the dome switch, between the points 404, 406. When the externally applied force on the touch-sensitive display 118 falls below the release threshold, the charge at the piezo disk 206 is adjusted or varied, e.g., modulated, to impart a force, by the piezo actuators 120 on the touch-sensitive-display 118, to increase the charge over a relatively short period of time to simulate release of a switch, such as a dome switch, between the points 408, 410. The charge on the piezo disk 206 is removed to reduce the force applied by the piezo actuators 120 over a longer period of time between the points 410, 412.

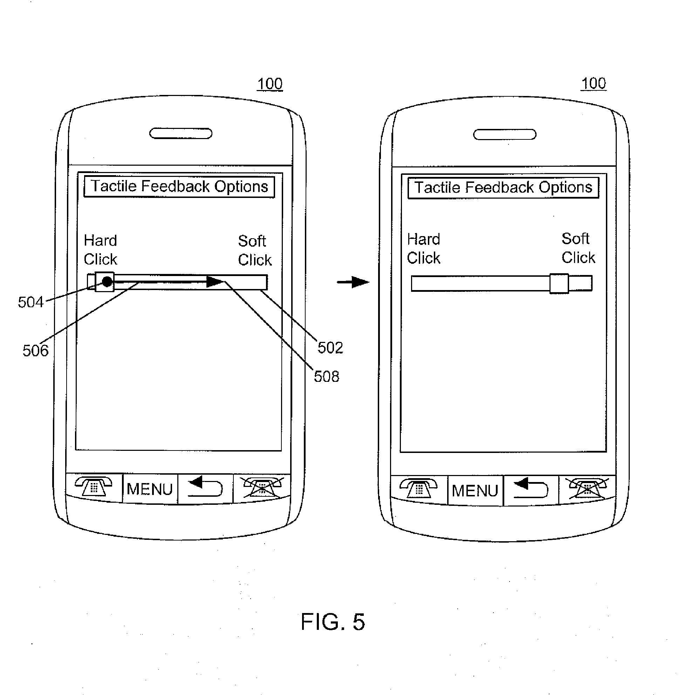

The tactile feedback may be adjusted by factors including, for example, the time of simulation of depression of a switch, e.g., collapse of the dome switch, the time of simulation of release of the switch, such as a dome switch, the threshold, the release threshold, the maximum charge on the piezo disks 206, and any combination of these factors. An example of touch-sensitive display 118 before and after adjustment of a response setting is shown in FIG. 5. The response setting may be adjusted, for example, via a settings submenu that is displayed on the touch-sensitive display 118 of the portable electronic device 100 and by receiving input to select the adjustable response setting via the touch-sensitive display. In this example, a single setting is display in the form of a slider 502 on the touch-sensitive display 118, for adjusting the tactile feedback between a "hard click" and a "soft click". The adjustment may be made by a gesture beginning at an origin point along the slider 502 and following the path of the slider while touch contact is maintained. In this example, the gesture begins at an origin point 504 and follows the path of the arrow 506 to the end point 508. In this example, the tactile feedback is adjusted by changing the depression threshold and the release threshold, and each location along the slider corresponds to different settings for the depression threshold and the release threshold. Thus, the depression threshold and the release threshold are established based on the slider setting. The gesture shown in FIG. 5 reduces the thresholds such that the ramp up and simulation of the depression of the switch, such as collapse of a dome switch, is initiated by a lower externally-applied force. The release threshold is also reduced such that the simulation of release of the switch, such as release of a dome switch, is initiated by a lower externally-applied force. Other gestures and display mechanisms may be utilized to input the adjustable response setting. A displayed button, for example, labeled "Try It" may also be provide in conjunction with the slider or other selection mechanism, such that the user may depress the button.

Optionally, other factors may be adjusted in combination with the depression threshold and the release threshold. For example, the time to discharge the piezo disks 206, for example, to simulate the depression of a switch, such as collapse of the dome switch, may be adjusted by increasing the time or decreasing the time. A shorter time provides a faster depression simulation and may be perceived as deeper depression of a switch as compared to a longer time. Similarly, the time to charge the piezo disks 206, to simulate release of the switch, may be adjusted by increasing the time or decreasing the time. A shorter time period provides a faster release simulation and may be perceived as a return from a deeper depression of the switch compared to a longer time period. These factors may be adjusted separately from the adjustment of the depression threshold and release threshold or a single adjustment such as the slider shown in FIG. 5 may control the combination of factors.

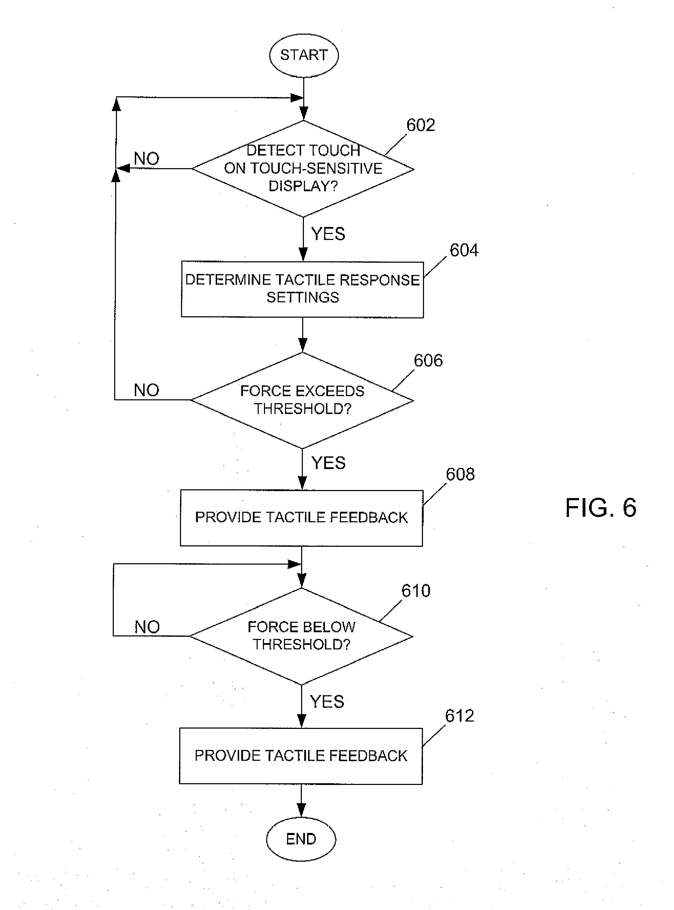

A flowchart illustrating a method of controlling an electronic device, such as a portable electronic device, is shown in FIG. 6. The method is advantageously performed by the processor 102 and the controller 116 performing stored instructions from a computer-readable medium. When a touch is detected 602, the location of the touch on the touch-sensitive display 118 is determined. The tactile response settings are determined 604. If the force of the touch on the touch-sensitive display 118 is determined 606 to exceed the depression threshold, tactile feedback is provided 608 by controlling the charge at the piezo actuators 120 to simulate depression of a switch, such as collapse of a dome switch. When the force on the touch on the touch-sensitive display 118 is determined 610 to fall below the release threshold, tactile feedback is provided 612 by controlling the charge at the piezo actuators 120 to simulate release of the switch, such as a dome switch.

A method includes determining an adjustable response setting for an electronic device, detecting a touch event on a touch-sensitive display of the electronic device, and imparting, by an actuator, a first force on the touch-sensitive display by increasing the first force over a ramp-up time period and reducing the first force over a depression time period, to simulate actuation of a switch based on the adjustable response setting.

A computer-readable medium has computer-readable code executable by at least one processor of a portable electronic device to perform the above method.

An electronic device includes a touch-sensitive display configured to provide an adjustable response setting and to detect a touch; and an actuator configured to impart a force on the touch-sensitive display by increasing the force over a ramp-up time period and reducing the force over a depression time period, to simulate actuation of a switch based on the adjustable response setting.

The tactile feedback may be adjusted by controlling factors such as the time of simulation of depression, such as collapse of the dome switch, the time of simulation of release, the depression threshold, the release threshold, the maximum charge on the piezo disks 206, and any combination of these factors. This facilitates selection of a desired response during entry using the touch-sensitive display. This control of the tactile feedback also facilitates adjustment to compensate for variations in force sensors and piezo actuators over the life cycle of the portable electronic device.

The present disclosure may be embodied in other specific forms without departing from its spirit or essential characteristics. The described embodiments are to be considered in all respects only as illustrative and not restrictive. The scope of the present disclosure is, therefore, indicated by the appended claims rather than by the foregoing description. All changes that come within the meaning and range of equivalency of the claims are to be embraced within their scope.

## Claims

1. A method comprising:
determining an adjustable response setting for an electronic device;
detecting a touch event on a touch-sensitive display of the electronic device; and
imparting, by an actuator, a first force on the touch-sensitive display by increasing the first force over a ramp-up time period and reducing the first force over a depression time period, to simulate actuation of a switch based on the adjustable response setting.

2. The method according to claim 1, wherein the depression time period is established based on the adjustable response setting.

3. The method according to claim 1 or claim 2, comprising determining a value of an external force applied to the touch-sensitive display prior to imparting the first response force.

4. The method according to claim 1, comprising comparing a value of a force applied to the touch-sensitive display to a threshold, wherein imparting the first force is carried out in response to determining that the applied force exceeds the threshold.

5. The method according to claim 4, wherein the threshold is established based on the adjustable response setting.

6. The method according to any one of claims 1 to 5, comprising imparting, by the actuator, a second force by Increasing the force over a release period of time and decreasing the second force over a ramp-down period of time.

7. The method according to claim 6, wherein the release period of time is established based on the adjustable response setting.

8. The method according to claim 1, comprising determining a value of an external force applied to the touch-sensitive display after imparting the first force.

9. The method according to claim 8, comprising comparing the value to a second threshold and wherein imparting the second force is carried out in response to determining that the force value falls below the second threshold.

10. The method according to claim 9, wherein the second threshold is established based on the adjustable response setting.

11. The method according to claim 1, wherein the ramp up time period is longer than the depression time period to simulate actuation of a switch based on the adjustable response setting.

12. The method according to claim 1, wherein determining the adjustable response setting comprises receiving input to select the adjustable response setting via the touch-sensitive display.

13. A computer-readable medium having computer-readable code executable by at least one processor of a portable electronic device to perform the method according to any one of claims 1 to 12.

14. A portable electronic device comprising:
a touch-sensitive display configured to provide an adjustable response setting and to detect a touch; and
an actuator configured to impart a force on the touch-sensitive display by increasing the force over a ramp-up time period and reducing the force over a depression time period, to simulate actuation of a switch based on the adjustable response setting.

15. The portable electronic device of claim 14, comprising a processor configured to determine the adjustable response setting by receiving input, via the touch-sensitive display, to select the adjustable response setting.

## Amended claims

### Amended claims in accordance with Rule 137(2) EPC.

**1.** A method comprising:
determining an adjustable response setting for an electronic device;
detecting a touch event on a touch-sensitive display of the electronic device; and
impacting, by an actuator, a first force on the touch-sensitive display by increasing the first force over a ramp-up time period and reducing the first force over a depression time period, to simulate actuation of a switch based on the adjustable response setting.

**2.** The method according to claim 1, wherein the depression time period is established based on the adjustable response setting.

**3.** The method according to claim 1 or claim 2, comprising determining a value of an external force applied to the touch-sensitive display prior to imparting the first response force.

**4.** The method according to claim 1, comprising comparing a value of a force applied to the touch-sensitive display to a threshold, wherein imparting the first force is carried out in response to determining that the applied force exceeds the threshold, and preferably, wherein the threshold is established based on the adjustable response setting.

**5.** The method according to claim 1, wherein tactile feedback simulating actuation of a switch is provided in response to depression of the touch-sensitive display.

**6.** The method according to any one of claims 1 to 5, comprising imparting, by the actuator, a second force by increasing the force over a release period of time and decreasing the second force over a ramp-down period of time.

**7.** The method according to claim 6, wherein the release period of time is established based on the adjustable response setting.

**8.** The method according to claim 1, comprising determining a value of an external force applied to the touch-sensitive display after imparting the first force.

**9.** The method according to claim 8, comprising comparing the value to a second threshold and wherein imparting the second force is carried out in response to determ ning that the force value falls below the second threshold.

**10.** The method according to claim 9, wherein the second threshold is established based on the adjustable response setting.

**11.** The method according to claim 1, wherein the ramp up time period is longer than the depression time period to simulate actuation of a switch based on the adjustable response setting.

**12.** The method according to claim 1, wherein determining the adjustable response setting comprises receiving input to select the adjustable response setting via the touch-sensitive display.

**13.** A computer-readable medium having computer-readable code executable by at least one processor of a portable electronic device to perform the method according to any one of claims 1 to 12.

**14.** A portable electronic device comprising:
a touch-sensitive display configured to provide an adjustable response setting and to detect a touch; and
an actuator configured to impart a force on the touch-sensitive display by increasing the force over a ramp-up time period and reducing the force over a depression time period, to simulate actuation of a switch based on the adjustable response setting.

**15.** The portable electronic device of claim 14, comprising a processor configured to determine the adjustable response setting by receiving input, via the touch-sensitive display, to select the adjustable response setting.
